# EUROPEAN PATENT SPECIFICATION

(11) **EP 0 876 691 B1**
(45) Date of publication and mention of the grant of the patent: **05.04.2000**
(21) Application number: 96933660.1
(22) Date of filing: 21.10.1996
(51) Int. Cl.: H01R 12/04, H01R 12/32

(54) **SOLDER ELEMENT**
LÖTELEMENT
ELEMENT DE BRASAGE

(30) Priority: 20.10.1995 NL 1001453
(43) Date of publication of application: 11.11.1998
(73) Proprietor: Koninklijke Philips Electronics N.V., 5621 BA Eindhoven (NL)
(72) Inventor: GODIJN, Paul, Willem, NL-1273 WB Huizen (NL); OUD, Martinus, Adrianus, NL-2925 DK Krimpen a/d IJssel (NL); DEKKER, Jan, NL-3993 EB Houten (NL); WELLING, Antonius, Johannes, NL-1412 DG Naarden (NL); DE KEIZER, Johannes, Cornelis, NL-3871 MK Hoevelaken (NL)
(74) Representative: Bos, Kornelis Sjoerd
(86) International application number: NL9600410
(87) International publication number: WO9715097

(56) References cited:
- EP-A- 0 126 164
- DE-A- 3 624 412
- FR-A- 2 403 711
- US-A- 3 852 517
- US-A- 4 345 814

## Description

The invention relates to a solder element suitable for making electrically conducting connections between electrically conductive members on opposite surfaces of a printed circuit board, said element comprises an electrically conducting wire provided with a body composed of solder material and flux material.

DE-A1-36 24 412 describes a method for making a switch connection between both surfaces of a substrate, in particular a printed circuit board, wherein use is made of an electrically conductive wire provided with rings of solder material and flux material. The ends of the wire of the solder element are inserted through holes in the printed circuit board. The solder material remains on that side of the printed circuit board where the electrical components are situated. The solder element is soldered on the printed circuit board during its passage through a soldering apparatus, such as a wave soldering apparatus. During this passage, flux material is first foamed on the side of the printed circuit board remote from the electrical components. In the solder bath the ends of the wire are soldered to the conductive members, while under the influence of heat conduction the solder ring on the other side of the printed circuit board melts so that the wire is soldered to the conductive member on the opposite surface. In DE-A1-36 24 412 there is however no indication where the flux material is arranged on the solder material of the rings. Usually the flux material is applied on the outside of the solder material. This must be done before the soldering element is inserted in the printed circuit board, because applying flux material on the side of the printed circuit board where the electrical components are also situated is undesirable as a consequence of a supposedly harmful effect of the flux material on the electrical components. This has the disadvantage that the handling of the solder element is inconvenient with respect to the storage of the solder elements and the insertion operation. Machine parts of the automatic insertion machine will become filthy, causing interruption and failures during the insertion operation. Moreover flux material on the outside of the solder material will easily become lost during all handling.

The present invention has for its object to provide a solder element with which the above stated drawbacks are obviated as far as possible.

The present invention is therefore characterized in that the flux material is enclosed in an axial direction of the wire between two parts of the solder material, while leaving in a substantially radial direction an open link for the flux material to its surroundings. The flux material is now enclosed between parts of the solder material, so that it is safely stored, while the open link to its surroundings results in a good outflow of flux material and consequently in a good wetting of the conductive member of the printed circuit board during the soldering operation.

According to a first embodiment the body of solder material is provided with a recess in which the flux material is accommodated. By directing the recess in a direction toward the conductive member of the printed circuit board during the insertion operation, the flux material flows easy out of this recess under the influence of heat in the direction of the conductive member, so that a good and reliable connection is obtained.

According to a second embodiment the flux material is accommodated between two bodies of solder material. The solder element can now be inserted in the printed circuit board in any direction. The flux material flows always toward the conductive member.

The invention will now be described, by way of example, with reference to the accompanying drawings, wherein:
figure 1 shows a solder element which is not part of the invention;
figures 2-4 each show a view of different embodiments of the solder element according to the invention;
figures 5 and 6 show the method for making electrically conducting soldered connections on two sides of the printed circuit board with the solder element shown in figure 2;
figure 7 shows a view of a variant corresponding with figure 6; and
figure 8 shows a series of solder elements 2 which are arranged at mutual distance between two mutually adhered strips of adhesive tape.

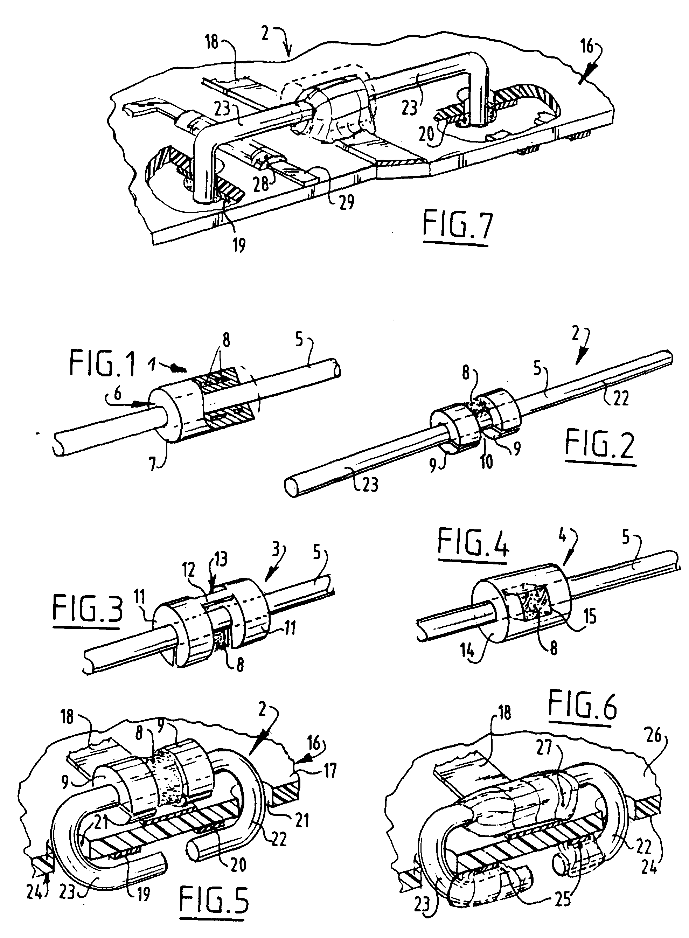

Figure 1 shows a solder element 1 in a general manner which is not part of the invention. Solder element 1 comprises an electrically conducting wire 5 around which is arranged a cylindrical solder body 6 which consists of solder material 7 in which is incorporated flux material 8.

Figure 2 shows a solder element according to the invention built up of an electrically conducting wire 5 and two solder bodies 9 constructed as split rings and clamped as such on wire 5. The annular space 10 is filled with flux material 8 which is therefore enclosed in axial direction by the solder bodies 9.

Figure 3 shows a solder element 3 according to the invention which is built up of two solder bodies 11 which take the form of a split ring, which solder bodies 11 are connected by a cross-piece 12, whereby the two bodies 11 are connected non-releasably to each other. This ensures a desired distance between the two bodies 11 and therefore ensures that a determined quantity of flux material 8 fills the space 13 located between bodies 11.

Figure 4 shows another solder element 4 according to the invention which comprises a substantially cylindrical solder body 14 provided with a radially directed recess 15 which is filled with flux material 8.

It will be apparent that, when heat is supplied to these solder elements, in the case of the solder elements 3 and 4 the outflow of flux material in particular directions can be prevented (by cross-piece 12) or enhanced by the direction of the recess 15.

Figures 5 and 6 show a method for making electrically conducting soldered connections on a printed circuit board 16 which comprises a non-conducting base 17 of plastic material having selectively arranged thereon strips 18-20 of electrically conducting material lying at a distance from the perimeter of the bores 21 arranged in the base 17.

As shown in figure 5, the solder element 2 is placed with its legs protruding through bores 21 and bent round on the other side so that the solder element 2 cannot leave the printed circuit board 16 in undesirable manner.

The printed circuit board 16 is subsequently guided through a solder apparatus wherein the underside 24 is provided with flux material and then solder material, whereby the legs 22 and 23 are welded via a soldered connection 25 to the strips 19 and 20.

No flux material and solder material reaches the top side 26 but an adequate soldered connection 27 can be formed there according to the invention in that under the influence of heat the flux material 8 first flows and both the bodies 9 then melt to form the soldered connection to the electrically conducting strip 18.

In the situation shown in figure 7 the solder element 2 extends with its leg 23 over an electrically conducting strip 29 provided with an electrically insulating layer 28. It is thus possible to realize an electrically conducting soldered connection between the strips 18, 19 and 20 while the electrically conducting strip 29 is bridged by solder element 2. This provides further freedom in the designing of printed circuit boards.

As electrically conducting wire for solder elements according to the invention any normal electrically conducting material can be used, such as copper.

As solder material can be applied any typical solder material such as Sn/43Pb43/Bi14. As flux material can be applied any normal flux material as long as it flows before the solder material melts. Typical flux materials can for instance be used which contain 0.35% w/w halides.

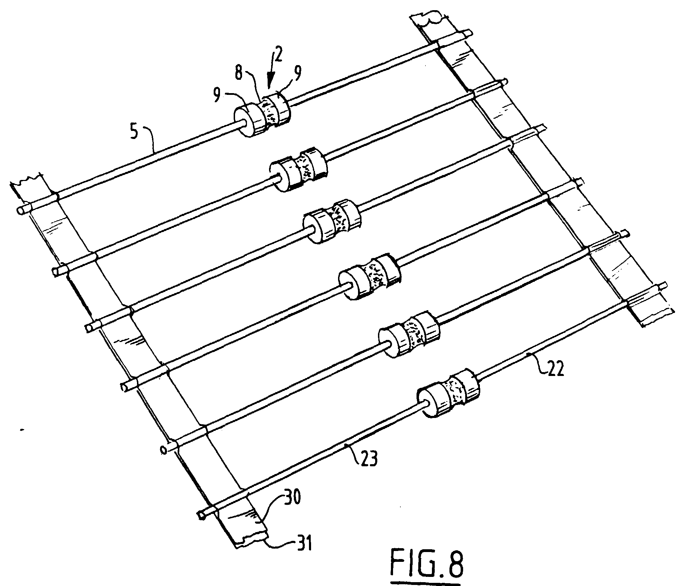

Figure 8 shows a plurality of solder elements 2 which are arranged with the electrically conducting wire at mutual distance between two strips of adhesive tape 30, 31.

The solder elements can be mounted in the printed circuit board 16 in simple manner, for instance with a robot, in that the wire 5 between the strips of adhesive tape 30, 31 is cut out, wherein the length of the legs 22, 23 can still be chosen.

## Claims

1. Solder element suitable for making electically conducting connections between electrically conductive members (18,19,20) on opposite surfaces (24,26) of a printed circuit board (16), said element comprises an electrically conducting wire (5) provided with a body (9) composed of solder material (7) and flux material (8), characterized in that the flux material (8) is enclosed in an axial direction of the wire (5) between two parts of the solder material (7), while leaving in a substantially radial direction an open link for the flux material to its surroundings.

2. Solder element as claimed in claim 1, characterized in that the body (9) of solder material is provided with a recess (15) in which the flux material (8) is accommodated.

3. Solder element as claimed in claim 1, characterized in that the flux material (8) is accommodated between two bodies (9,11) of solder material.

## Patentansprüche

1. Lötelement, geeignet zum Herstellen elektrisch leitender Verbindungen zwischen elektrisch leitenden Elementen (18, 19, 20) auf einander gegenüberliegenden Oberflächen (24, 26) einer Printplatte (16), wobei dieses Element einen elektrisch leitenden Draht (5) aufweist, der mit einem Körper (9) versehen ist, der aus Lötmittel (7) und Flussmittel (8) zusammengesetzt ist, dadurch gekennzeichnet, dass das Flussmittel (8) in axialer Richtung des Drahtes (5) zwischen zwei Teilen des Lötmittels (7) eingeschlossen ist, während in einer hauptsächlich radialen Richtung eine offene Verbindung für das Flussmittel zu der Umgebung frei gelassen wird.

2. Lötelement nach Anspruch 1, dadurch gekennzeichnet, dass der Körper (9) aus Lötmittel mit einer Ausnehmung (15) versehen ist, in der das Flussmittel (8) untergebracht ist.

3. Lötelement nach Anspruch 1, dadurch gekennzeichnet, dass das Flussmittel (8) zwischen zwei Körpern (9, 11) aus Lötmittel untergebracht ist.

## Revendications

1. Elément de brasage approprié à réaliser des connexions électriquement conductrices entre des éléments électriquement conducteurs (18, 19, 20) sur des surfaces opposées (24, 26) d'un panneau à circuit imprimé (16), ledit élément étant muni d'un fil électriquement conducteur (5) présentant un corps (9) qui est composé d'un matériau de soudure (7) et d'un matériau de flux (8), caractérisé en ce que le matériau de flux (8) est enfermé dans une direction axiale du fil (5) entre deux parties du matériau de soudure (7), tout en laissant, dans une direction radiale, une liaison ouverte pour le matériau de flux avec ses environs.

2. Elément de brasage selon la revendication 1, caractérisé en ce que le corps (9) en matériau de soudure est muni d'un évidement (15) dans lequel est logé le matériau de flux (8)

3. Elément de brasage selon la revendication 1, caractérisé en ce que le matériau de flux (8) est logé entre deux corps (9, 11) réalisés en matériau de soudure.
